# EUROPEAN PATENT SPECIFICATION

(11) **EP 0 614 328 B1**
(45) Date of publication and mention of the grant of the patent: **20.01.1999**
(21) Application number: 94908111.1
(22) Date of filing: 20.08.1993
(51) Int. Cl.: H05K 3/46

(54) **COMPOSITE MOLDED PRODUCT HAVING THREE-DIMENSIONAL MULTI-LAYERED CONDUCTIVE CIRCUITS AND METHOD OF ITS MANUFACTURE**
VERBUNDFORMKÖRPER MIT DREIDIMENSIONALEN MEHRSCHICHTIGEN LEITFÄHIGEN SCHALTUNGEN UND VERFAHREN ZU SEINER HERSTELLUNG
PRODUIT MOULE COMPOSITE POSSEDANT DES CIRCUITS CONDUCTEURS MULTICOUCHES TRIDIMENSIONNELS ET PROCEDE POUR SA FABRICATION

(30) Priority: 20.08.1992 JP 221331/92
(43) Date of publication of application: 07.09.1994
(73) Proprietor: POLYPLASTICS CO. LTD., Chuo-Ku Osaka-shi Osaka 541 (JP)
(72) Inventor: MIYASHITA, Takayuki, Fuji-shi, Shizuoka 416 (JP)
(74) Representative: Jackson, Peter
(86) International application number: JP9301168
(87) International publication number: WO9405141

(56) References cited:
- JP-A- 3 078 291
- JP-A- 4 035 085
- JP-A- 4 332 193
- JP-A-61 252 687
- JP-A-61 289 698
- JP-A-63 034 996
- IBM TECHNICAL DISCLOSURE BULLETIN., vol.33, no.7, December 1990, NEW YORK US page 37, XP000108400 'Injection-molded inner plane circuit board'
- PATENT ABSTRACTS OF JAPAN vol. 13, no. 325 (E-792) 21 July 1989 & JP-A-01 091 444 (MEIKI CO) 11 April 1989
- PATENT ABSTRACTS OF JAPAN vol. 12, no. 218 (M-711) 22 June 1988 & JP-A-63 016 886 (SANKYO KASEI KK) 23 January 1988

## Description

The present invention relates to a composite molded article such as a multi-layered circuit substrate having a three-dimensional conduction circuit, and to a composite molded article which can be prepared efficiently and will be suitably utilized for electric and electronic components such as a chassis incorporating a circuit board, an IC memory card, and so forth.

A method of producing a composite molded article having multi-layered conduction circuits is disclosed in JP-A 3-78291.

### [Brief Description of the Drawings]

Fig. 1 is a perspective view showing an example of a primary molded article as a three-dimensional circuit substrate according to the present invention.

Fig. 2 is a perspective view showing the state where a circuit pattern is formed on the surface of the primary molded article (Fig. 1), wherein (a) shows one side (the face) and (b) shows the other side (the back).

Fig. 3 is a perspective view showing the state where a multi-layered circuit substrate was formed by using two primary molded articles (Fig. 2) having the circuit pattern formed thereon and making them composite by secondary molding.

Fig. 4 shows a composite molded substrate (finished product) having a three-dimensional conduction circuit formed by boring through-holes in the multi-layered circuit substrate (Fig. 3) and establishing electric conduction of each layer by plating the inside of the through-holes, wherein (a) is a perspective view thereof and (b) is a sectional view taken along a line X - X of (a).

Fig. 5 is a perspective view showing a primary molded substrate to be incorporated and sealed as another embodiment of the present invention.

Fig. 6 is a perspective view showing the state where a circuit pattern is formed on the surface of the primary molded substrate (Fig. 5), wherein (a) shows the face and (b) shows the back of (a).

Fig. 7 shows a secondary molded substrate incorporating and sealing the primary molded substrate (Fig. 6) having the circuit pattern, wherein (a) is a perspective view of the appearance and (b) is a sectional view taken along a line X'- X' of (a).

Fig. 8 shows the state where a circuit pattern is further formed on the surface of the secondary molded three-dimensional circuit substrate (Fig. 7) and plating is effected inside the through-holes, wherein (a) is a perspective view of the appearance and (b) is a sectional view taken along a line X" - X" of (a).
1 primary molded article
2 three-dimensional circuit pattern of primary molded article (the face)
2' circuit pattern of primary molded article (the back)
3 secondary molded portion
4 through-hole of secondary molded article
5 through-hole of primary molded substrate
5' through-hole of secondary molded three-dimensional circuit substrate
6 primary molded substrate
7 circuit pattern of primary molded substrate (the face)
7' circuit pattern of primary molded substrate (the back)
8 secondary molded three-dimensional substrate incorporating and sealing primary molded substrate
9 circuit pattern of the face of secondary molded three-dimensional circuit substrate

### [Prior Art]

Conventionally, as a method of producing a multi-layered circuit substrate, a method is generally adopted, which comprises sandwiching an insulating material such as a glass fabric impregnated with an epoxy resin between layers of circuit substrates, and heating and pressing them by a hot press. According to this method, however, position errors are likely to occur during heating and pressing, therefore, it is difficult to form a correct multi-layered circuit substrate. Particularly when each circuit substrate is three-dimensional, sufficient adhesion cannot be obtained between the layers, and a problem of production efficiency remains to be solved, too. A thick film printing method which comprises alternately printing and coating a conductive paste and a dielectric paste (an insulating agent) to a sintered ceramic substrate, drying and sintering repeatedly, and connecting upper and lower layers with one another through via-holes formed in the dielectric layers so as to form a multi-layered circuit, and a green sheet lamination method which comprises printing a conductor on an unsintered, green ceramic sheet (green sheet), laminating and pressing these sheets, and sintering them finally, are also known. However, when a three-dimensional circuit is formed according to these methods, a surface shape is likely to be lost greatly because printing and baking are repeated and production processes are also complicated.
Accordingly, it has been difficult to efficiently form a three-dimensional circuit having a high level of accuracy.

### [Disclosure of the Invention]

The present inventors have conducted extensive studies on a method of efficiently producing a multi-layered circuit substrate having a three-dimensional conduction circuit so as to solve these problems with the prior art, and have now reached the present invention.

Namely, the present invention relates to a method of producing a composite molded article having a three-dimensional multi-layered conduction circuit, which comprises the following sequence of steps: molding a primary molded article of a thermoplastic resin or a thermosetting resin; forming a desired conduction circuit on a front and/or back side of the primary molded article; fixing one or more said primary molded articles having the circuit formed thereon to a mold for secondary molding; effecting injection molding using a thermoplastic molding material for secondary molding to mold a composite secondary molded article incorporating and sealing therein the whole or a part of the circuit of the one or more primary molded articles; forming, if desired, further a desired conduction circuit on the surface of the secondary molded article to form a composite molded article having at least two or more layers of conduction circuits; boring through-holes penetrating through predetermined positions of the layer circuits during, or after, the primary and secondary molding operations; effecting a metal coating processing to the inner surface of the through-holes; and forming conduction portions at predetermined positions of the layer circuits.

The present invention furthermore relates to a composite molded article formed by the above mentioned method.

Hereinafter, the method of the present invention will be explained with reference to the drawings.

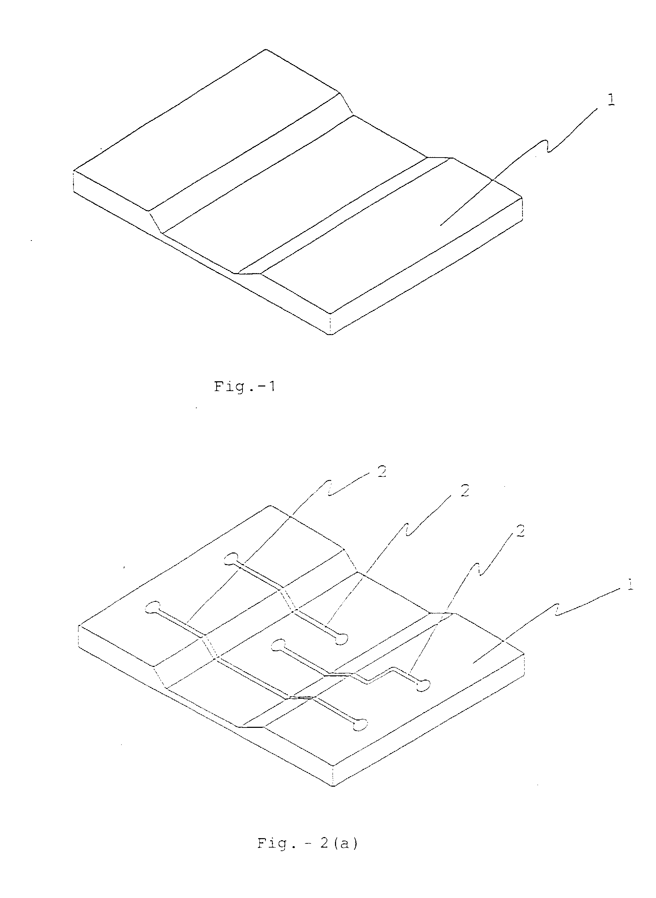

A primary molded article according to the present invention is a substrate having a three-dimensional shape such as shown in Fig. 1, and formed by using a thermoplastic or thermosetting resin material capable of forming a metal film circuit on the surface thereon with high adhesion. Such a substrate is molded by injection molding, or like means. Any resin materials can be used so long as they have high adhesion with a metal, but from the aspect of high producibility, a thermoplastic resin is preferred. A blend composition containing an inorganic filler for improving adhesion with a metal, for example, can be used preferably.

Preferably, this resin material has by itself a high mechanical property, particularly a high strength, and has a high melting point, a high strength and a high rigidity so as to accurately maintain an intended shape and to be free from deformation and breakage due to heat and external force particularly during secondary molding. From these aspects, a thermoplastic resin such as a liquid crystal polymer (e.g. liquid crystal polyester), polyarylene sulfide, polyacetal, polyalkylene terephthalate, is preferred. Among them, liquid crystal polyester, polyphenylene sulfide and the like are particularly preferred, because they can reduce the thickness of the substrate. To improve adhesion of a metal film as a surface circuit pattern, surface treatment suitable for the materials employed, such as chemical etching using an acid, an alkali or the like, or physical surface treatment such as corona discharge, plasa treatment or the like, may be applied to this primary molded article, as occasion demands.

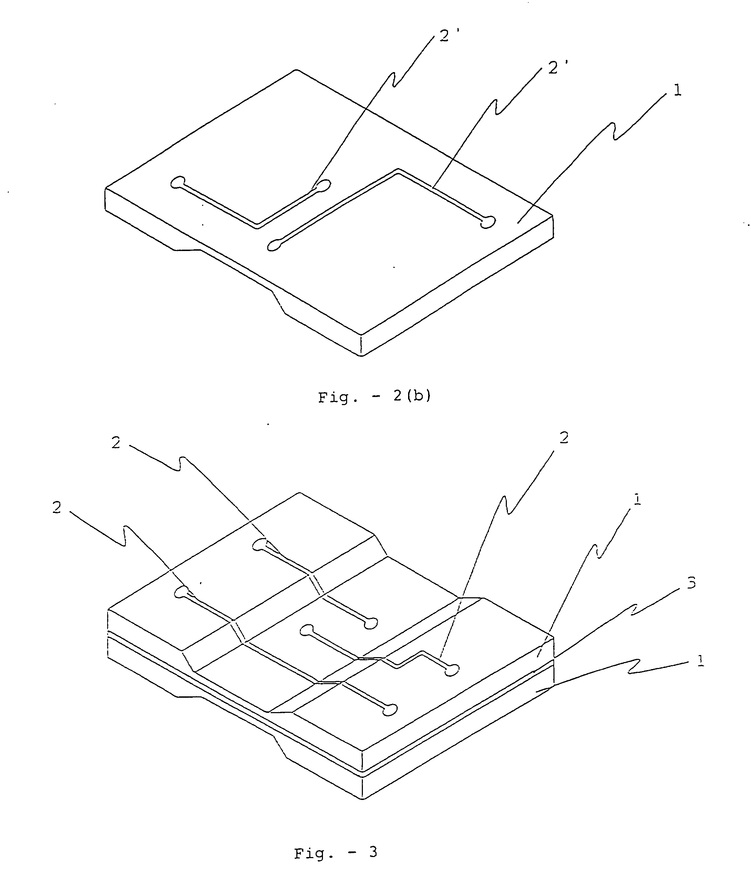

Next, a desired circuit pattern is formed on one or both sides of this primary molded article (Fig. 2). With respect to the forming of the circuit pattern 2, 2', a conductive film having a suitable thickness is formed by a known method such as plating, sputtering, vacuum deposition, ion plating, transfer, coating of a conductive agent, etc, and then a desired circuit pattern is formed by subtractive process or semi-additive process.

The primary molded article 1 having the circuit pattern 2, 2' formed thereon (Fig. 2) is subjected to surface cleaning, drying, etc, whenever necessary, and is then used for secondary molding.

To effect secondary molding, one or two or more primary molded articles having predetermined circuit patterns formed thereon are fixed to a predetermined position of a mold for secondary molding. When two or more primary molded articles are used, they are fixed with a predetermined gap between them. Composite molding is then attained to integrate them by injection molding using a thermoplastic molding material for secondary molding so that the circuit pattern 2' is buried and moreover, a desired outer shape can be shaped. In this case, the circuit pattern of the primary molded article used may be the same or the primary molded articles having two or more different kinds of patterns may be combined depending on the intended object.

The resin material for secondary molding is not particularly limited, and may be selected suitably in consideration of various properties in accordance with the object of use of the circuit substrate, and so forth. In view of fusion with the primary molded article and of adhesion with the metal coated portion, however, it is preferably the same as, or analogous to, the resin of the primary material. To prevent the circuit pattern 2' of the primary molded article 1 from loosing its shape during secondary molding, it is preferable to use a material the melting point of which is the same as, or lower than, the melting point of the primary molded article. A material requiring a molding temperature by far higher than the melting point of the primary molded article is not preferred. Further, a material having high fluidity is preferred.

Fig. 3 shows a secondary molded article having a three-dimensional circuit pattern 2 formed on the outer layer, wherein the respective circuit patterns 2', 2' are buried by secondary molding while opposing each other.

Namely, the composite molded article according to the present invention comprises an integrated assembly of at least two or more layers of circuits, and may be of such a type in which a circuit is formed on only one side of the primary molded article, and after the circuits are made composite by secondary molding, a circuit is formed on the surface of the secondary molded article. It is also possible to obtain a composite molded article having a multi-layered circuit using two or more circuit substrates which are formed by forming circuits on both sides of the primary molded article.

In the present invention, through-holes 4 are formed so as to establish electric connection between necessary predetermined portions of each layer of the circuit of the composite molded article having a multi-layered circuit. The through-holes are formed by arranging the circuit pattern of each layer in such a manner that predetermined positions of the conduction circuit pattern of each layer to be connected coincide with one another, boring the through-holes at such positions and applying a metal film to the inner surface of each through-hole. In this way, they play the role of forming conduction connection portions at predetermined positions of the circuit of each layer.

The through-holes may be bored after molding of the composite molded article. Alternatively, they may be formed in advance during molding of the primary molded article, carrying out secondary molding so as to form through-holes in such a manner as to coincide with the former, and forming the predetermined through-holes simultaneously with molding of the composite molded article.

The latter method provides the advantage that the primary molded article can be fixed to the predetermined positions of the mold for secondary molding by utilizing the through-holes already formed during primary molding.

In this way, the composite molded article having the metal conduction portions formed inside the through-holes thus becomes a composite molded article with a built-in three-dimensional multi-layered circuit wherein each circuit pattern is arranged in multiple layers and the desired portions of circuit of each layer are connected with one another to establish electric conduction.

Namely, the composite molded article with the built-in multi-layered circuit according to the present invention can be an integral molded component that incorporates other elements and components connected with a part of the circuit.

The composite molded article formed by the method of the present invention such as a substrate having three-dimensional multi-layered conduction circuit can be produced efficiently, and can provide circuit components incorporating therein a group of cubically complicated and diversified circuits more correctly and more compactly than that formed by methods of the prior art. Moreover, since the composite molded article of the present invention provides a protection effect of circuit portions, it is useful as a large number of electric and electronic components.

Next, examples of the present invention will be explained definitely with figures, but the present invention is not particularly limited thereto.

### Example 1

A primary molded substrate 1 (Fig. 1) is formed by injection-molding, using a liquid crystal polyester resin composition (trade name; "Vectra", mfd. by Polyplastics K.K.). Next, copper plating is applied to the surface of this primary molded article. After an etching resist is coated, a circuit pattern is exposed. The substrate is immersed into a copper etching solution to dissolve copper, the etching resist is then removed, and circuit patterns 2, 2' are formed on both sides of the molded article (Fig. 2).

Next, two primary molded articles 1 (Fig. 2) having this circuit pattern formed thereon are fitted and fixed to a mold for secondary molding with a suitable gap between them in such a manner that the respective circuit portions 2', 2' oppose each other, and the gap portion is molded by injection-molding using the same resin. In this way, a secondary molded article (Fig. 3) having the respective circuit patterns 2' built therein is molded.

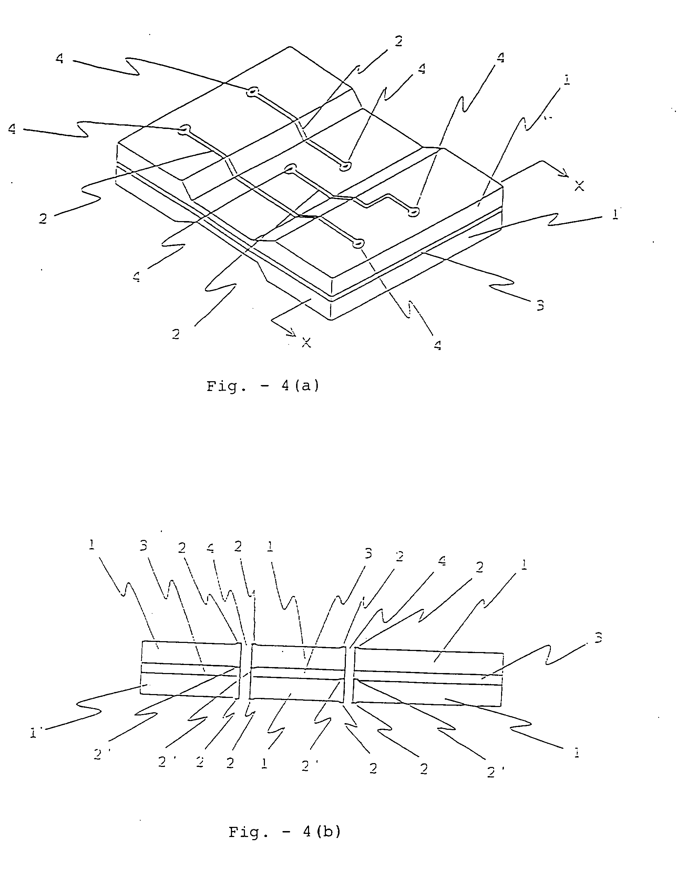

Next, through-holes 4 are bored at predetermined positions of the circuit portion of this secondary molded article (Fig. 3), and the inner surface of the molded article (Fig. 4(b)) is plated by chemical copper plating so as to establish electric conduction between the circuits of the respective layers. In this way, a multi-layered circuit substrate having a three-dimensional conduction circuit (Fig. 4) is obtained.

### Example 2

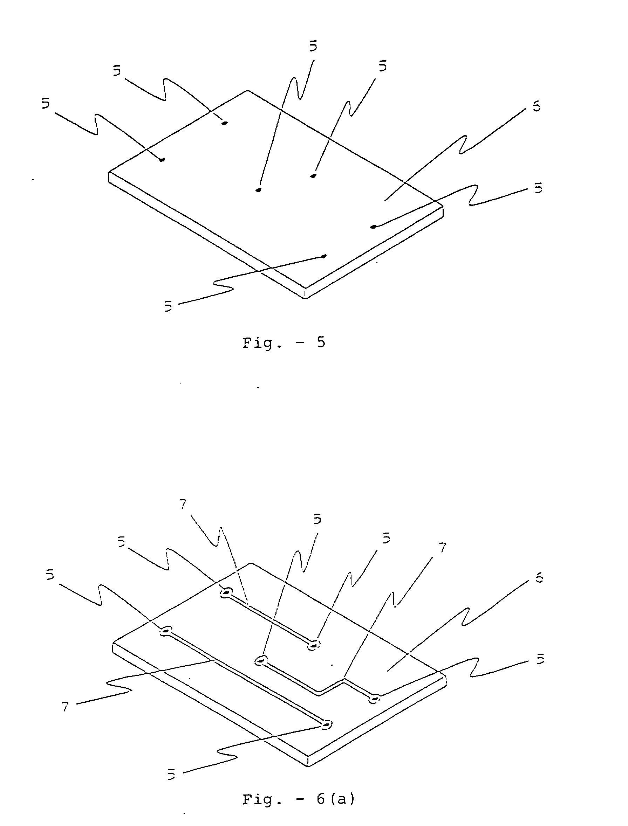

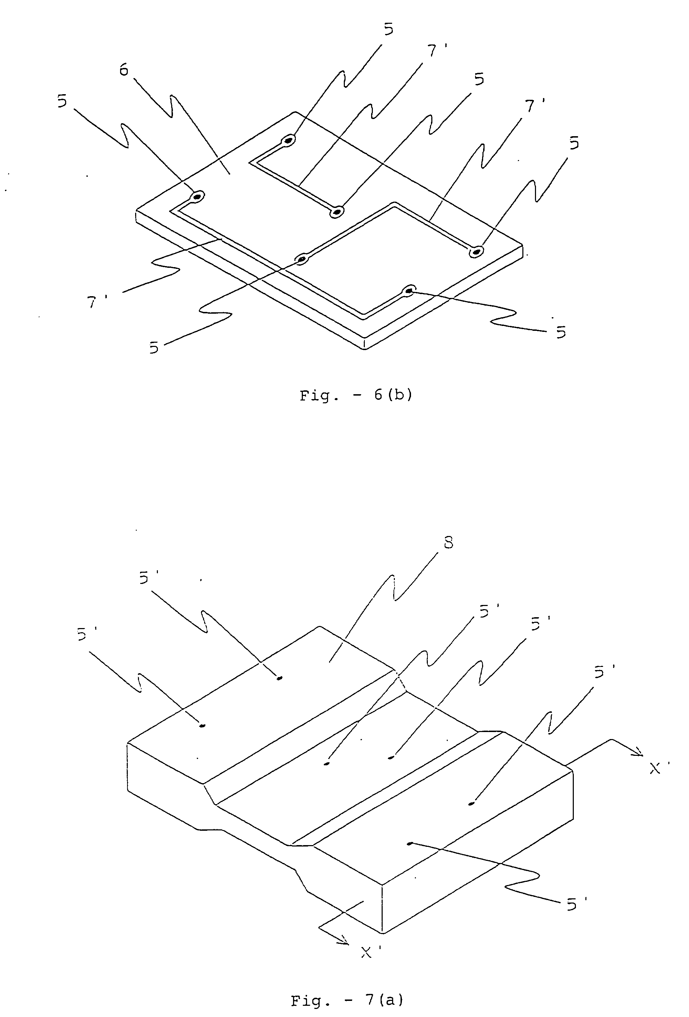

A planar molded substrate 6 (Fig. 5) having in advance the through-holes 5 is produced by injection molding using the same liquid crystal polyester resin composition as that of the fore-going example. Next, copper plating is applied to the face and back of this primary molded article, and an etching resist is coated. A circuit pattern is exposed, and the molded article is immersed into a copper etching solution to dissolve copper. The etching resist is then removed, and circuit patterns 7, 7' overlapping with the through-holes 5 at predetermined positions are formed (Fig. 6).

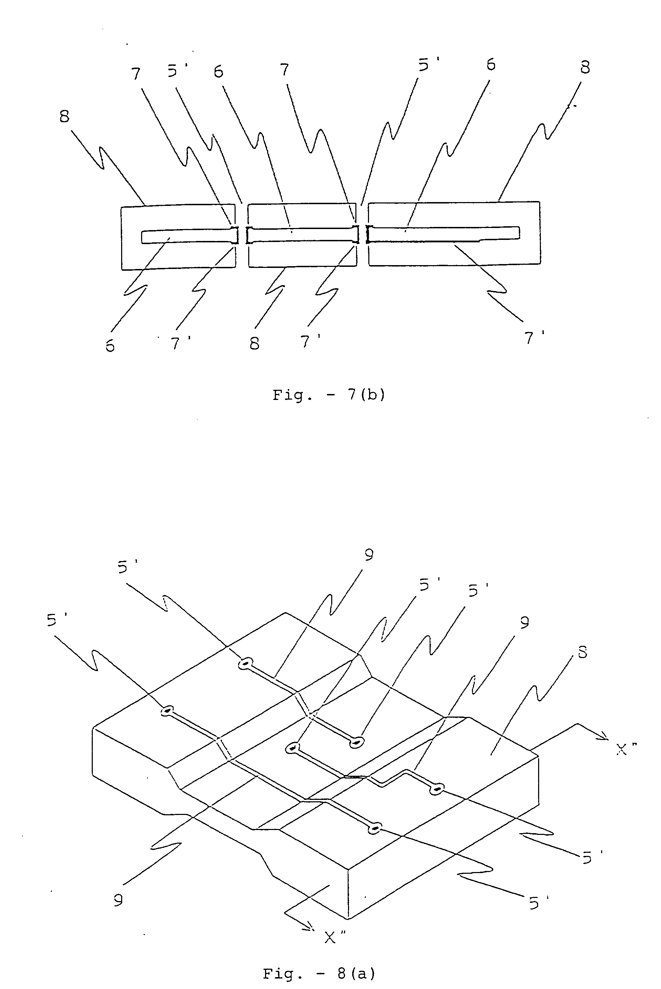

Next, the primary molded articles 6 (Fig. 6) having the circuit patterns 7, 7' formed thereon are supported by, and fixed to, a mold for secondary molding at the positions of the through-holes 5, and secondary molding is carried out by injection molding using the same resin. In this way, a secondary molded article 8 (Fig. 7) having the through-holes 5' at the positions overlapping with the through-holes 5 of the primary molded article and embedding therein the primary molded articles 6 is produced.

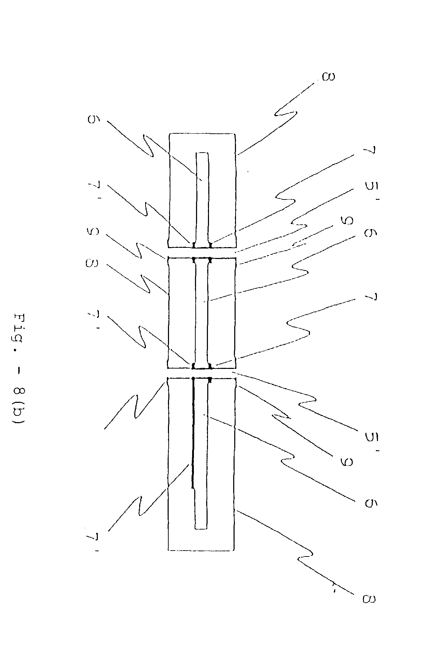

Next, copper plating is applied in the same manner as described above, to the entire surface of the secondary molded article 8 (Fig. 7) having the circuit patterns 7, 7' incorporated therein and to the inner surface of the through-holes 5' (Fig. 7(b)), and circuit patterns are further formed on both sides of the secondary molded article by the same method (Fig. 8(b)). In this way, a composite molded substrate (Fig. 8) having a three-dimensional multi-layered conduction circuits, is obtained, wherein inner and outer four layers are electrically connected by the through-hole portions.

## Claims

1. A method of producing a composite molded article having a three-dimensional multi-layered conduction circuit characterized by the following sequence of steps comprising:
molding a primary molded article of a thermoplastic resin or a thermosetting resin;
forming a desired conduction circuit on a front and/or back side of said primary molded article;
fixing one or more said primary molded articles having the circuit formed thereon to a mold for secondary molding;
effecting injection molding using a thermoplastics molding material for secondary molding to mold a composite secondary molded article incorporating and sealing therein the whole or a part of said circuit of said one or more primary molded articles;
forming, if desired, further a desired conduction circuit on the surface of said secondary molded article to form a composite molded article having at least two or more layers of conduction circuits;
boring through-holes penetrating through predetermined positions of said layer circuits during, or after, said primary and secondary molding operations;
effecting a metal coating processing to the inner surface of said through-holes; and
forming conduction portions at predetermined positions of said layer circuits.

2. A composite molded article having a three-dimensional multi-layered conduction circuit formed by said method described in claim 1.

## Patentansprüche

1. Verfahren zur Herstellung eines Verbundstoff-Formkörpers mit einer dreidimensionalen, mehrschichtigen Schaltung, dadurch gekennzeichnet, daß es die folgende Abfolge von SChritten umfaßt:
Formpressen eines primären Formkörpers aus einem thermoplastischen Harz oder einem duroplastischen Harz;
Bilden einer gewünschten Schaltung auf der Vorderund/oder Rückseite des primären Formkörpers;
Befestigen eines oder mehrerer der primären Formkörper mit der darauf gebildeten Schaltung an einer Form zum sekundären Formpressen;
Spritzgießen unter Verwendung einer thermoplastischen Formmasse für sekundäres Formpressen, so daß ein sekundärer Verbundstoff-Formkörper geformt wird, der den gesamten oder einen Teil der Schaltung des einen oder der mehreren primären Formkörper enthält oder einschließt;
falls gewünscht, weiterhin Bilden einer gewünschten Schaltung auf der Oberfläche des sekundären Formkörpers unter BIldung eines Verbundstoff-Formkörpers, der wenigstens zwei oder mehr Schichten mit Schaltungen aufweist;
Bohren von Durchkontaktlöchern, die durch vorbestimmte Positionen der Schichtschaltungen dringen, während oder nach der primären und sekundären Formpreßoperation;
Metallisieren der inneren Oberfläche der Durchkontaktlöcher; und
Bilden leitender Teile auf vorbestimmten Positionen der Schichtschaltungen.

2. Verbundstoff-Formkörper mit einer dreidimensionalen, mehrschichtigen Schaltung, der durch das in Anspruch 1 beschriebene Verfahren gebildet wird.

## Revendications

1. Procédé de fabrication d'un article moulé composite ayant un circuit conducteur multicouche tridimensionnel, caractérisé en ce qu'il comprend la séquence d'étapes suivante :
le moulage d'un article moulé primaire en résine thermoplastique ou résine thermodurcissable ;
la formation d'un circuit conducteur souhaité sur l'endroit et/ou l'envers dudit article moulé primaire ;
la fixation d'un ou plusieurs desdits articles moulés primaires sur lesquels les circuits sont formés, à un moule pour moulage secondaire ;
la réalisation d'un moulage par injection en utilisant une matière à mouler thermoplastique pour le moulage secondaire, pour mouler un article moulé composite secondaire incorporant et scellant en son sein tout ou partie desdits circuits desdits un ou plusieurs articles moulés primaires ;
la formation ensuite, si on le souhaite, d'un circuit conducteur souhaité sur la surface dudit article moulé secondaire pour former un article moulé composite ayant au moins deux ou plusieurs couches de circuits conducteurs ;
le perçage de trous d'interconnexion pénétrant à travers des positions prédéterminées desdites couches de circuits pendant, ou après, lesdites opérations de moulage primaire et secondaire ;
la réalisation d'un traitement de revêtement métallique sur la surface interne desdits trous d'interconnexion ; et
la formation de parties conductrices à des positions prédéterminées desdites couches de circuits.

2. Article moulé composite ayant un circuit conducteur multicouche tridimensionnel formé par ledit procédé décrit dans la revendication 1.
